# EUROPEAN PATENT SPECIFICATION

(11) **EP 3 985 479 B1**
(45) Date of publication and mention of the grant of the patent: **17.04.2024**
(21) Application number: 20825613.1
(22) Date of filing: 19.06.2020
(51) Int. Cl.: G06F 1/16, G06F 3/044, G06F 3/041

(54) **ELECTRONIC DEVICE COMPRISING OPAQUE LAYER**
ELEKTRONISCHE VORRICHTUNG MIT EINER OPAKEN SCHICHT
DISPOSITIF ÉLECTRONIQUE COMPRENANT UNE COUCHE OPAQUE

(30) Priority: 19.06.2019 KR 20190072746
(43) Date of publication of application: 20.04.2022
(73) Proprietor: Samsung Electronics Co., Ltd., Gyeonggi-do 16677 (KR)
(72) Inventor: HEO, Hoondo, Suwon-si Gyeonggi-do 16677 (KR); JUNG, Songhee, Suwon-si Gyeonggi-do 16677 (KR); HER, Yongkoo, Suwon-si Gyeonggi-do 16677 (KR); KIM, Jungtae, Suwon-si Gyeonggi-do 16677 (KR); OH, Wooyoung, Suwon-si Gyeonggi-do 16677 (KR)
(74) Representative: HGF
(86) International application number: PCT/KR2020/007955
(87) International publication number: WO 2020/256461

(56) References cited:
- EP-A1- 3 423 917
- KR-A- 20100 037 763
- KR-A- 20160 027 893
- KR-A- 20170 088 262
- KR-B1- 101 360 206
- KR-B1- 101 899 906
- US-A1- 2013 076 649
- US-A1- 2015 002 761
- US-A1- 2016 066 412

## Description

### [Technical Field]

Various embodiments disclosed herein relate to an electronic device. For example, various embodiments relate to an electronic device including an opaque layer provided on a display.

### [Background Art]

As electronic information communication technology has developed, various functions have come to be integrated into a single electronic device. For example, a smart phone includes functions of, for example, an audio reproduction device, an imaging device, a digital diary, in addition to a communication function, and more various functions may be implemented in the smart phone through additional installation of applications. An electronic device may be provided with various pieces of information in real time by accessing a server or another electronic device in a wired or wireless manner as well as by executing an installed application or a stored file.

As it becomes more common to carry or use an electronic device such as a smart phone, user demand for the appearance of the electronic device is diversified. In order to meet various user needs, a housing made of various materials such as a metal material, a glass material, or a ceramic material may be applied to the exterior of the electronic device. As another method to meet various user needs, the screen display area of a display may be maximized within an allowable range of the external surface area of the electronic device. When a corner portion of the exterior of an electronic device is processed as a curved line or a curved surface, a grip feeling when the electronic device is held in a hand may be improved, thereby increasing user satisfaction.

EP 3 423 917 A1 relates to an electronic device including a display. US 2013/0076649 A1 relates to electronic devices with sidewall displays. US 2016/0066412 A1 relates to a curved display and an electronic device including the curved display.

### [Detailed Description of the Invention]

### [Technical Problem]

A screen display area of a general display has a rectangular or square shape, and a corner portion of the front surface of the electronic device may be processed as a curved line. However, when the front surface of the electronic device has a shape corresponding to the screen display area of the display, a wider screen display area may be secured in the limited external surface area of the electronic device. For example, as the corner of the electronic device is closer to a right angle, it is possible to secure a wider rectangular or square screen display area. However, as the curved edge of the electronic device has a larger curvature, the area ratio of the screen display area (e.g., the rectangular or square screen display area) to the external surface area (e.g., the area of the front surface) of the electronic device may become smaller.

By processing the corners in the exterior of the electronic device in a curved surface (or a curved line) to improve the visual design or grip feeling, and processing the corners of the screen display area in a curved line to match the external appearance of the electronic device, it is possible to improve the area ratio of the screen display area to the area of the front surface of the electronic device. However, due to the shape of the pixels disposed in the screen display area, when the edge of the screen display area is enlarged in a curved section, the actual shape may form a shape other than a curved line (e.g., a wave shape, a zigzag shape, or a step shape). For example, a curved section at an edge of the screen display area may be visually recognized by the user as a wave shape, a sawtooth shape, or a step shape.

In an embodiment, by electrically controlling the pixel(s) disposed in the curved section of the screen display area, it is possible to improve the curved section of the screen display area recognized as a sawtooth shape or a step shape. However, in controlling the pixel(s) disposed in the curved section, power consumption of a processor or memory may increase, and efficiency may decrease. An increase in power consumption or a decrease in efficiency may be further severe when output screens are rapidly changed, for example, in sports relay screens or game screens.

Various embodiments may provide an electronic device including an opaque layer corresponding to pixels arranged along a curved trajectory at an edge of a screen display area.

Various embodiments may to provide an electronic device in which a curved section of a screen display area that is visually recognized in a sawtooth shape or a step shape is improved using an opaque layer.

Various embodiments may provide an electronic device that is improved screen quality in a curved section of a screen display area while being improved in terms of utilization efficiency or power consumption of a processor or memory.

### [Technical Solution]

According to various embodiments disclosed herein, an electronic device may include a housing including a front plate oriented in a first direction, a rear plate oriented in a second direction opposite to the first direction, and a side structure disposed to at least partially surround a space between the front plate and the rear plate, a display disposed between the front plate and the rear plate and including a plurality of pixels to output a screen through the front plate, wherein, when viewed from above the front plate, the display includes at least one curved section in which the pixels are arranged, at the edge of a screen display area, along a curved trajectory, and an opaque layer disposed to correspond to at least a curved section of the screen display area. When viewed from above the front plate, the opaque layer may cover at least some of the pixels arranged in the curved section.

According to various embodiments disclosed herein, the electronic device may include a housing including a front plate, a rear plate facing away from the front plate, and a side structure surrounding a space between the front plate and the rear plate, a display configured to output a screen through the front plate and including an edge, at least a portion which is formed in a curved section when viewed from above the front plate, a touch sensor disposed between the front plate and the display, and a conductive opaque layer extending to cover at least a portion of the curved section when viewed from above the front plate and electrically connected to the touch sensor.

### [Advantageous Effects]

According to various embodiments disclosed herein, the electronic device has a corner in the shape of a curved line or curved surface, whereby it is possible improve a visual design or a grip feeling. In an embodiment, the display includes a curved section corresponding to the shape of the curved line or a curved surface of the electronic device in the screen display area, whereby it is possible to improve the ratio of the area of the screen display area to the external surface area (e.g., the area of the front surface) of the electronic device. In another embodiment, the opaque layer is arranged to correspond to the pixels arranged to form a sawtooth shape or a step shape in a curved section of the screen display area, whereby it is possible to improve the edge of the screen display area recognized in a sawtooth shape or the step shape. For example, the opaque layer may improve the aesthetic quality of the electronic device by making an edge of the screen display area take a smooth curved line shape. In another embodiment, the electronic device does not need to perform electrical control for improving the curved section of the display recognized in a sawtooth shape or a step shape. Thus, it is possible to improve the electronic device in terms of efficiency of utilization of a processor or memory or power consumption.

### [Brief Description of Drawings]

FIG. 1 is a perspective view illustrating an electronic device according to one of various embodiments disclosed herein.
FIG. 2 is a rear perspective view illustrating the electronic device of FIG. 1.
FIG. 3 is an exploded perspective view illustrating an electronic device according to one of various embodiments disclosed herein.
FIG. 4 is an enlarged view illustrating a portion of an electronic device according to one of various embodiments disclosed herein.
FIG. 5 is a cross-sectional view illustrating a portion of an electronic device according to one of various embodiments disclosed herein.
FIG. 6 is a cross-sectional view illustrating a portion of an electronic device according to another one of various embodiments disclosed herein.
FIG. 7 is an enlarged view illustrating a portion of an electronic device according to one of various embodiments disclosed herein.
FIGS. 8 and 9 are views for describing an example of implementing an opaque layer in an electronic device according to various embodiments disclosed herein.
FIG. 10 is a view illustrating a portion of an electronic device according to still another one of various embodiments disclosed herein.

### [Mode for Carrying out the Invention]

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B", "at least one of A and B", "at least one of A or B", "A, B, or C", "at least one of A, B, and C", and "at least one of A, B, or C", may include any one of, or all possible combinations of the items enumerated together in a corresponding one of the phrases. As used herein, such terms as "1st" and "2nd", or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with", "coupled to", "connected with", or "connected to" another element (e.g., a second element), it means that the element may be coupled with the other element directly (e.g., wiredly), wirelessly, or via a third element.

As used in connection with the disclosure, the term "module" may include a unit implemented in hardware, software, or firmware, and may interchangeably be used with other terms, for example, "logic", "logic block", "part", or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program) including one or more instructions that are stored in a storage medium (e.g., internal memory or external memory) that is readable by a machine (e.g., the electronic device). For example, a processor (e.g., the processor) of the machine (e.g., the electronic device) may invoke at least one of the one or more instructions stored in the storage medium, and execute it. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semipermanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. According to various embodiments, one or more of the above-described components or operations may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

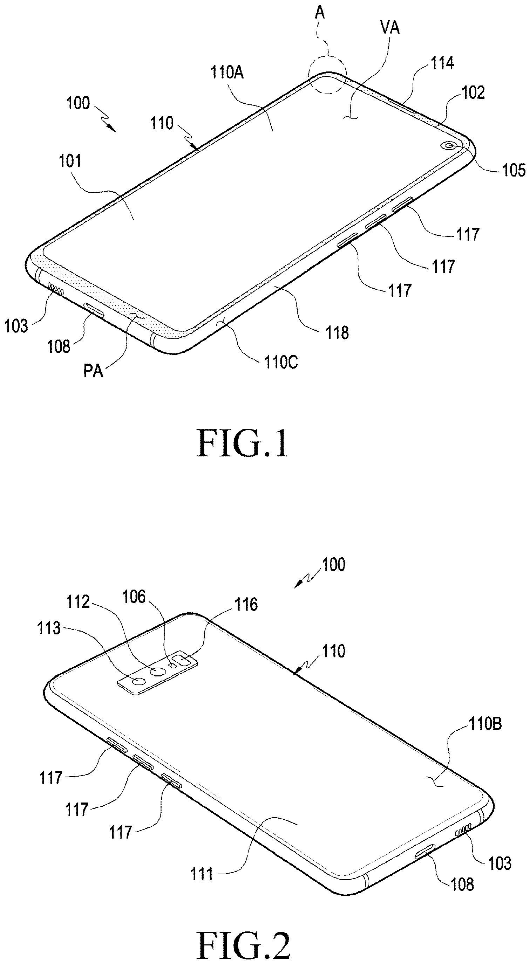

FIG. 1 is a perspective view illustrating an electronic device 100 according to one of various embodiments disclosed herein. FIG. 2 is a rear perspective view illustrating the electronic device 100 of FIG. 1.

Referring to FIGS. 1 and 2, the electronic device 100 according to an embodiment includes a housing 110 including a first surface (or a front surface) 110A, a second surface (or a rear surface) 110B, and a side surface 110C (or a side wall) surrounding the space between the first surface 110A and the second surface 110B. In another embodiment (not illustrated), the term "housing 110" may refer to a structure forming a part of the first surface 110A, the second surface 110B, and the side surface 110C of FIG. 1.

According to an embodiment, at least a portion of the first surface 110A is defined by a substantially transparent front plate 102 (e.g., a glass plate or a polymer plate including various coating layers). According to an embodiment, the front plate 102 may include a curved portion bent and seamlessly extending from the first surface 110A toward the rear plate 111 in at least one side edge portion.

According to various embodiments, the second surface 110B may be defined by a substantially opaque rear plate 111. The rear plate 111 may be made of, for example, coated or colored glass, ceramic, a polymer, a metal (e.g., aluminum, stainless steel (STS), or magnesium), or a combination of two or more of these materials. According to an embodiment, the rear plate 111 may include a curved portion bent and extending seamlessly from the second surface 110B towards the front plate 102 in at least one side edge portion.

According to various embodiments, the side surface 110C may be formed by a side structure ("a side member" or "a side wall") 118 coupled to the front plate 102 and the rear plate 111 and including metal and/or polymer. In some embodiments, the rear plate 111 and the side structures 118 are integrated with each other and may include the same material (e.g., a metal material such as aluminum).

According to an embodiment, the electronic device 100 includes a display 101, and may include at least one of audio modules 103 and 114, a sensor module, an opening area 105, key input devices 117, and a connector hole 108. In an embodiment, the electronic device 100 may include an optical module (e.g., a camera module, a light source, a proximity sensor, or an illuminance sensor) disposed to correspond to the opening area 105. In some embodiments, in the electronic device 100, at least one of the components (e.g., the key input devices 117) may be omitted, or other components may be additionally included. For example, the electronic device 100 may include a sensor module (not illustrated). For example, in an area provided by the front plate 102, a sensor, such as a proximity sensor or an illuminance sensor, may be integrated into the display 101 or disposed at a position adjacent to the display 101. In some embodiments, the electronic device 100 may further include a light-emitting element, and the light-emitting element may be disposed at a position adjacent to the display 101 in the area provided by the front plate 102. The light-emitting element may provide, for example, the status information of the electronic device 100 in an optical form. In another embodiment, the light-emitting element may provide, for example, a light source that is interlocked with the operation of an optical module (e.g., a camera module) disposed in the opening area 105. The light-emitting element may include, for example, an LED, an IR LED, and a xenon lamp.

The display 101 is exposed through, for example, a considerable portion of the front plate 102. In some embodiments, a corner of the display 101 may be formed to be substantially the same as an adjacent outer shape of the front plate 102 (e.g., a curved line or curved surface shape of a portion indicated by reference number "A"). In another embodiment (not illustrated), the distance between the periphery of the display 101 and the periphery of the front plate 102 may be substantially constant in order to enlarge the exposed area of the display 101. For example, when viewed from above the front plate 102, a screen display area VA of the display 101 and the peripheral area PA (e.g., a black matrix area) disposed around the screen display area VA may be provided substantially on the front surface (e.g., the first surface 110A) of the electronic device 100, and the area of the screen display area VA may be 90% or more (substantially 100%) of the area of the first surface 110A. In another embodiment (not illustrated), a recess or an opening (e.g., the opening area 105) may be provided in a portion of the screen display area VA of the display 101, and another electronic component aligned with the recess or the opening (e.g., the opening area 105), such as a camera module, a proximity sensor, or an illuminance sensor (not illustrated), may be included.

In another embodiment (not illustrated), at least one of camera modules 112 and 113, a fingerprint sensor 116, and a flash 106 may be included on the rear surface of the screen display area VA of the display 101. In another embodiment (not illustrated), the display 101 may be coupled to or disposed adjacent to a touch-sensitive circuit, a pressure sensor capable of measuring a touch intensity (pressure), and/or a digitizer configured to detect a magnetic field-type stylus pen.

The audio modules 103 and 114 may include a microphone hole and a speaker hole. The microphone hole may include a microphone disposed therein so as to acquire external sound. In some embodiments, multiple microphones may be disposed in the microphone hole so as to detect the direction of sound. In some embodiments, the speaker hole and the microphone hole may be implemented as a single hole, or a speaker (e.g., a piezo speaker) may be included without a speaker hole. The speaker hole may include an external speaker hole and a phone call receiver hole 114.

By including a sensor module (not illustrated), the electronic device 100 may generate an electrical signal or data value corresponding to an internal operating state or an external environmental condition. The sensor module may further include, for example, a proximity sensor disposed on the first surface 110A of the housing 110, a fingerprint sensor incorporated in the display 101, and/or a biometric sensor (e.g., an HRM sensor) disposed on the second surface 110B of the housing 110. The electronic device 100 may further include at least one of sensor modules (not illustrated), such as a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

The camera modules 112, 113, and 106 may include a first camera device (e.g., a camera module disposed to correspond to the opening area 105) disposed on the first surface 110A of the electronic device 100, and second camera devices 112 and 113 disposed on the second surface 110B, and/or a flash 106. The camera devices 112 and 113 may include one or more lenses, an image sensor, and/or an image signal processor. The flash 106 may include, for example, a light-emitting diode or a xenon lamp. In some embodiments, two or more lenses (e.g., an infrared camera lens, a wide-angle lens, and a telephoto lens) and image sensors may be disposed on one surface of the electronic device 100.

The key input devices 117 may be disposed on the side surface 110C of the housing 110. In another embodiment, the electronic device 100 may not include some or all of the above-mentioned key input devices 117, and a key input device 117, which is not included in the electronic device 300, may be implemented in another form, such as a soft key, on the display 101. In some embodiments, the key input devices may include a fingerprint sensor 116 disposed on the second surface 110B of the housing 110.

The connector hole 108 may accommodate a connector configured to transmit and receive power and/or data to and from an external electronic device and/or a connector configured to transmit and receive an audio signal to and from an external electronic device. For example, the connector hole 108 may include a USB connector or an earphone jack.

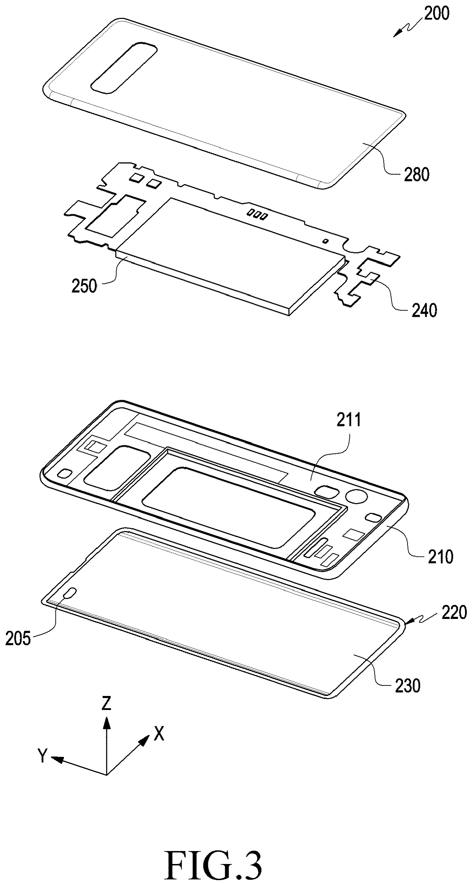

FIG. 3 is an exploded perspective view illustrating an electronic device (e.g., the electronic device 100 in FIG. 1) according to one of various embodiments disclosed herein.

Referring to FIG. 3, the electronic device 200 may include a side structure 210 (e.g., the side structure 118 in FIG. 1), an intermediate plate, for example, a first support member 211 (e.g., a bracket), a front plate 220 (e.g., the front plate 102 in FIG. 1), a display 230 (e.g., the display 101 in FIG. 1), a printed circuit board 240, a battery 250, and rear plate 280. According to an embodiment, the display 230 may be disposed between the front plate 220 and the rear plate 280, and in the thickness direction Z of the electronic device 200, the printed circuit board 240 may be disposed behind the display 230 (e.g., between the display 230 and the rear plate 280). In an embodiment, the first support member 211 may be disposed between the display 230 and the printed circuit board 240 to provide an electromagnetic isolation structure between the display 230 and the printed circuit board 240. In some embodiments, in the electronic device 200, at least one of the components (e.g., the first support member 211) may be omitted, or other components may be additionally included. At least one of the components of the electronic device 200 may be the same as or similar to at least one of the components of the electronic device 100 of FIG. 1 or 2, and a redundant description thereof will be omitted below.

In an embodiment, when viewed from above the front plate 220, the opening area 205 (e.g., the opening area 105 in FIG. 1) provided in the display 230 may have, for example, an elongated hole shape extending in the widthwise direction X of the electronic device 200. In various embodiments disclosed herein, the term "opening area" may refer to an area defined by a hole provided through the display 230 (e.g., the display 101 of FIG. 1) in the screen display area VA. In some embodiments, the "opening area" may mean a transparent area which is surrounded by the screen display area VA and in which no pixels are disposed. For example, the opening area 205 may provide a path through which light is incident from the exterior to the interior of the front plate 220. In another embodiment, the opening area 205 may provide a path through which light is emitted from the interior of the front plate 220 to the exterior.

The first support member 211 may be disposed inside the electronic device 200, and may be connected to the side structure 210 or may be integrated with the side structure 210. The first support member 211 may be made of, for example, a metal material and/or a non-metal material (e.g., a polymer). The display 230 may be coupled to one surface of the first support member 211, and the printed circuit board 240 may be coupled to the other surface of the first support member 211. On the printed circuit board 240, a processor, a memory, and/or an interface may be mounted. The processor may include one or more of, for example, a central processing unit, an application processor, a graphics processor, an image signal processor, a sensor hub processor, or a communication processor.

The memory may include, for example, a volatile memory or a nonvolatile memory.

The interface may include, for example, a high-definition multimedia interface (HDMI), a universal serial bus (USB) interface, an SD card interface, and/or an audio interface. The interface may electrically or physically connect, for example, the electronic device 200 to an external electronic device and may include a USB connector, an SD card/an MMC connector, or an audio connector.

The battery 250 is a device for supplying power to at least one component of the electronic device 200, and may include, for example, a non-rechargeable primary battery, a rechargeable secondary battery, or a fuel cell. At least a portion of the battery 250 may be disposed on substantially the same plane as, for example, the printed circuit board 240. The battery 250 may be integrally disposed inside the electronic device 200, or may be detachably disposed on the electronic device 200.

In describing various embodiments disclosed herein below, the components that can be easily understood with reference to the preceding embodiment may be denoted by the same reference numerals or the reference numerals may be omitted, and the detailed descriptions thereof may be omitted. In describing the following embodiments, reference may be made to the drawings or configurations of the preceding embodiments for the sake of brevity of the drawings or detailed description.

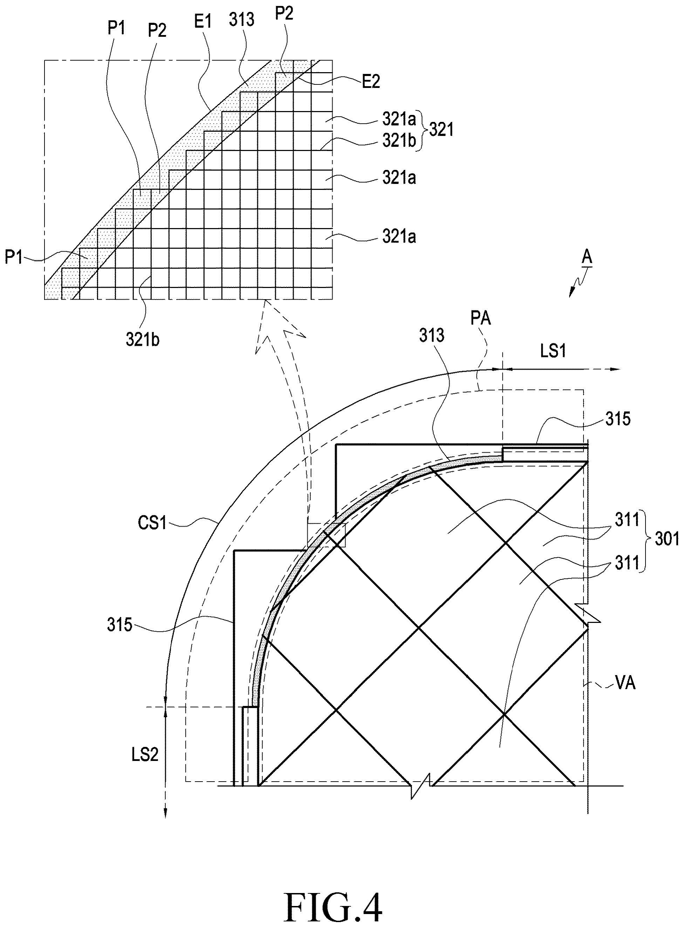

FIG. 4 is an enlarged view illustrating a portion of an electronic device (e.g., the electronic device 100 or 200 of FIG. 1 or 3) according to one of various embodiments disclosed herein.

FIG. 4 is an enlarged perspective view illustrating, for example, a part A of FIG. 1. When viewed from above the front plate (e.g., the front plate 102 or 220 in FIG. 1 or 3), at least a portion of an edge of the screen display area VA has a curved line shape (e.g., the first curved section CS1), and the electronic device (e.g., the electronic device 100 or 200 of FIG. 1 or 3) includes an opaque layer 313 corresponding to the first curved section CS1 of the area VA may be included. When viewed from above the front plate 102 or 220, the opaque layer 313 is provided to cover at least a portion of the screen display area VA in the first curved section CS1 (e.g., at least some of the pixel(s) arranged in the first curved section CS1). In FIG. 4, reference number "321" indicates respective pixels constituting the screen display area VA, and among the pixels 321, the pixels arranged in the first curved section CS1 of the edge of the screen display area VA may be indicated by reference numerals "P1" and "P2" as needed.

According to various embodiments, in the screen display area (e.g., the screen display area VA in FIG. 1), a touch sensor 301 in which a plurality of transparent mesh electrodes 311 are disposed in combination may be disposed. In an embodiment, the "transparent mesh electrodes" may refer to electrodes that are not actually made of a transparent material and are formed to be very thin such that the electrodes cannot be identified with naked eye. For example, the display (e.g., the displays 101 or 230 in FIG. 1 or 3) may function as an input device for detecting a user's touch input while functioning as an output device for outputting a screen. A peripheral area (e.g., the peripheral area PA in FIG. 1) formed around the screen display area VA may include a portion of the front plate (e.g., the front plate 102 or 220 of FIG. 1 or 3) or a portion of the side structure (e.g., the side structure 210 in FIG. 3).

According to various embodiments, the screen display area VA includes an arrangement of a plurality of pixels 321. The pixels 321 may include a light-emitting area 321a and a boundary area 321b defining (or surrounding) the light-emitting area 321a. When the screen display area VA is viewed in an enlarged plan view, the boundary area 321b may have a substantially line shape, and a plurality of the boundary areas 321b may be combined with each other in the screen display area VA to provide a substantially grid-like pattern.

According to various embodiments, when viewed in a plan view, for example, when viewed from above of the front plate 102 or 220, at least a portion of an edge of the screen display area VA includes a first curved section CS1. In an embodiment, the first curved section CS1 may form a corner connecting two different straight sections LS1 and LS2 of the screen display area VA. For example, two straight sections LS1 and LS2 that are disposed to be inclined or perpendicular to each other among the edges of the screen display area VA may be connected via the first curved section CS1. The pixels 321 have, for example, a polygonal shape, for example, some of the pixels disposed at the edge of the screen display area VA (e.g., the pixels indicated by reference numbers "P1" and "P2") may be arranged along a curved trajectory to form the first curved section CS1. For example, in various embodiments disclosed herein, the term "curved section" may mean a section at an edge of the screen display area VA that appears as a curved line when compared with other straight sections. In an embodiment, the edge of the screen display area VA in the first curved section CS1 is identified or recognized as a curved shape when viewed with naked eyes, but may be visually recognized as a sawtooth shape or a step shape rather than as a perfect or smooth curve depending on a product.

According to various embodiments, the opaque layer 313 is disposed to correspond to at least the first curved section CS1 among at least the edges of the screen display area VA. According to an embodiment, the opaque layer 313 covers some of the pixels P1 and P2 arranged in the first curved section CS1. For example, when viewed from above the front plate 102 or 202, the pixels indicated by "P1" are positioned at the edge of the screen display area VA in the first curved section CS1 and may thus be partially or completely covered by the opaque layer 313. According to another embodiment, when viewed from above the front plate 102 or 202, the pixels indicated by "P2" are positioned at the edge of the screen display area VA in the first curved section CS1 so that a portion of each pixel may be covered by the opaque layer 313. For example, the light output from the pixels indicated by "P1" may be blocked by the opaque layer 313 so that the light cannot be emitted to the exterior of the electronic device (e.g., the electronic device 100 or 200 in FIG. 1 or 3), and a part of the light output from the pixels indicated by "P2" may be blocked by the opaque layer 313 and a remaining part of the light may be emitted to the exterior of the electronic device 100 or 200.

According to various embodiments, depending on the degree covered by the opaque layer 313, there may be a difference between the color of the light output from corresponding pixels and the light actually perceived by the user. According to an embodiment, the electronic device (e.g., the electronic device 100 or 200 of FIG. 1 or 3) may control each pixel partially covered by the opaque layer 313 to communicate with other surrounding pixels to output harmonized light (e.g., color or brightness). For example, the electronic device (e.g., the electronic device 100 or 200 in FIG. 1 or 3) can prevent image quality from being deteriorated by complementing the curved shape in the curved section of the screen display area (e.g., the screen display area VA) using the opaque layer 313. In an embodiment, the electronic device (e.g., the electronic device 100 or 200 in FIG. 1 or FIG. 3) may set or control the display (e.g., the display 101 or 230 in FIG. 1 or 3) such that the brightness gradually decreases toward the pixels covered by the opaque layer 313. In another embodiment, the electronic device 100 or 200 may set or control the display 101 or 230 such that saturation is gradually lowered toward the pixels covered by the opaque layer 313.

According to various embodiments, by disposing the opaque layer 313, an active area in which the pixels 321 are arranged and a screen display area (e.g., the screen display area VA) that can be actually visually recognized by the user from the exterior of the electronic device 100 or 200 may be slightly different from each other. This will be easily understood through the detailed description disclosed herein even though the "active area" and "the screen display area VA" may not be separately described in the following detailed description.

As mentioned above, when viewed from above the front plate 102 or 220, at least in the first curved section CS1, the opaque layer 313 may block a part of the light output from the screen display area VA to block emission to the exterior (e.g., the exterior of the electronic device 100 or 200). In an embodiment, by disposing the opaque layer 313 to at least partially cover the pixels P1 and P2 arranged in the first curved section CS1, it is possible to prevent the user from recognizing the first curved section CS1 of the screen display area VA as a sawtooth shape or a step shape. For example, in the first curved section CS1, the pixels P1 and P2 are arranged to form a sawtooth shape or a step shape, but the shape of the first curved section CS1 recognized by the user may be determined by the opaque layer 313.

According to various embodiments, when viewed from above the front plate 102 or 220, the edges of the screen display area VA may substantially overlap the opaque layer 313 or may be covered by the opaque layer 313 at least in the first curved section CS1. For example, with reference to the opaque layer 313, pixels (e.g., a light-emitting area) are not disposed outside the first side edge E1, and outside the second side edge E2 of the opaque layer 313, at least some of the pixels 321 and P2 may be disposed and a non-light-emitting area may not be disposed. As mentioned above, the screen display area VA of the display 101 or 230 visually perceived by the user may be determined by the opaque layer 313 rather than by the arrangement of the pixels P1 and P2 at least in the first curved section CS1. For example, the opaque layer 313 may prevent the shape of the screen display area VA from being visually recognized as a sawtooth shape or a step shape at least in the first curved section CS1. In some embodiments, the opaque layer 313 may be disposed to overlap the touch sensor 301, for example, under the area in which the transparent mesh electrodes 311 are arranged.

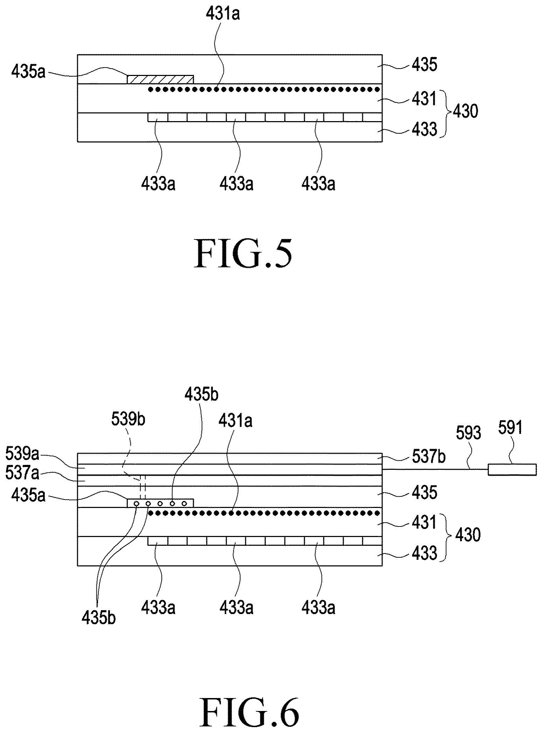

FIG. 5 is a cross-sectional view illustrating a portion of an electronic device (e.g., the electronic device 100 or 200 of FIG. 1 or 3) according to one of various embodiments disclosed herein.

Further referring to FIG. 5, a display 430 (e.g., the display 101 or 230 of FIG. 1 or 3) includes a first substrate 431 and a second substrate 433 coupled to face the first substrate 431. In an embodiment, since the second substrate 433 is coupled to face the first substrate 431, the pixels 433a (e.g., the pixels 321, P1, and P2 of FIG. 3) are sealed between the first substrate 431 and the second substrate 433. A touch sensor 431a (e.g., the touch sensor 301 in FIG. 4) is integrated into the first substrate 431. FIG. 5 illustrates the configuration in which the touch sensor 431a is disposed inside the first substrate 431. In unclaimed embodiments, the touch sensor may be integrated into a display (e.g., the display 230 in FIG. 3) or a front plate (e.g., the front plate 220 in FIG. 3), and may be disposed on the surface of the first substrate 431 or the front plate.

According to various embodiments, a dummy layer 435 may be stacked on the surface of the first substrate 431, and a portion of the dummy layer 435 may form the opaque layer 435a (e.g., the opaque layer 313 in FIG. 3). The opaque layer 435a is stacked on the first substrate 431. In some embodiments, the dummy layer 435 may include the opaque layer 435a, and in another embodiment, the opaque layer 435a may be made of a material different from that of the dummy layer 435, but may be disposed to form the same layer as the dummy layer 435. In the illustrated embodiment, a configuration in which the opaque layer 435a is located to be in contact with the first substrate 431 while being located inside the dummy layer 435 or partially at the same height as the dummy layer 435 is illustrated, but it should be noted that the present disclosure is not limited thereto. For example, unlike the structure illustrated in FIG. 5, the opaque layer 435a may be surrounded by the dummy layer 435 so as not to be in contact with the first substrate 431. In another embodiment, the opaque layer 435a may be disposed not to be in contact with the first substrate 431 while being partially at the same height as an upper surface or an outer surface of the dummy layer 435 of FIG. 5.

According to various embodiments, the opaque layer 435a may be disposed to correspond to (e.g., to at least partially overlap) an edge (e.g., the first curved section CS1 in FIG. 4) of the area in which the pixels 433a are arranged (e.g., the screen display area VA in FIG. 4). For example, a part of the light output from the pixels 433a at an edge of the screen display area VA is blocked by the opaque layer 435a not to be emitted to the exterior (e.g., the exterior of the electronic device 100 or 200 in FIG. 1 or 3). In an embodiment, a protective layer (not illustrated) may be stacked on the upper surface of the dummy layer 435 to protect the dummy layer 435 or the opaque layer 435a from an external environment. In an embodiment, the opaque layer 435a may be colored with the same color as the peripheral area (e.g., the peripheral area PA in FIG. 1 or 4).

Referring back to FIG. 4, the electronic device (e.g., the electronic device 100 or 200 in FIG. 1 or 3) may further include a signal wire 315. The opaque layer 435a includes at least one electrically conductive wire, and the electronic device 100 or 200 includes another touch sensor formed using the opaque layer 435a. An example in which the opaque layer 435a implements another touch sensor will be described with further reference to FIG. 6.

FIG. 6 is a cross-sectional view illustrating a portion of an electronic device (e.g., the electronic device 100 or 200 of FIG. 1 or 3) according to another one of various embodiments disclosed herein.

Referring to FIGS. 4 and 6, the opaque layer 435a may include a plurality of electrically conductive wires 435b or may be formed in combination with a plurality of electrically conductive wires 435b. A second touch sensor different from the touch sensor 431a is implemented using the arrangement of the electrically conductive wires 435b. By providing an additional touch sensor, the electronic device (e.g., the electronic device 100 or 200 in FIG. 1 or 3) may detect a touch input in a wider area or may be improved in the accuracy of the touch input. When the second touch sensor is implemented using the opaque layer 435a or the electrically conductive wires 435b, the electrically conductive wires 435b may be electrically connected to a printed circuit (e.g., the printed circuit board 240 in FIG. 3) via a signal wire (e.g., the signal wires 315 in FIG. 4), or may be electrically connected to a processor (e.g., the processor 591) mounted on the printed circuit board 240. For example, the processor 591 may be configured to detect a user's touch input using the electrically conductive wires 435b. In an embodiment, accuracy of a touch input may be improved as the additional touch sensor is disposed in the electronic device 100 or 200. In some embodiments, the second touch sensor formed of the opaque layer 435a or the electrically conductive wires 435b may be electrically connected to the touch sensor 431a. In another embodiment, an insulating material may be interposed in at least a portion between the opaque layer 435a and the touch sensor 431a.

According to various embodiments, a first insulating layer 537a may be provided on the surface of the dummy layer 435, and a wiring layer 539a may be provided on the surface of the first insulating layer 537a. For example, the signal wires 315 may be a part of the wiring layer 539a. In another embodiment, the touch sensor 431a may be disposed on the wiring layer 539a. For example, by including the second substrate 433 and a second insulating layer 537b to be described later, the touch sensor 431a is disposed on any layer between the second substrate 433 and the second insulating layer 537b. In some embodiments, the first insulating layer 537a and the dummy layer 435 may be layers formed of one or the same insulating material. For example, the first insulating layer 537a and the dummy layer 435 may be one layer providing an insulating structure, and the dummy layer 435 may be omitted and the opaque layer 435a may be formed inside the first insulating layer 537a, or the first insulating layer 537a may be omitted and the dummy layer 435 may function as the insulating layer.

In an embodiment, the electronic device 100 or 200 may include a via hole 539b formed through the first insulating layer 537a or the dummy layer 435 or an electric conductor filled in the via hole 539b. For example, the signal wires 315 may be electrically connected to the opaque layer 435a (e.g., the electrically conductive wireless 435b) via the via hole 539b or the electric conductor filled in the via hole 539b. In another embodiment, a second insulating layer 537b may be provided on the surface of the wiring layer 539a to protect the wiring layer 539a or the signal wire 315 from the external environment.

According to various embodiments, the wiring layer 539a may be electrically connected to the printed circuit board 240 (or the processor 591) via a connection board 593. In some embodiments, the electronic device 100 or 200 may output a screen or allow a touch input to be performed by including a driving chip(s) (not illustrated). In an embodiment, the connection board 593 is, for example, a flexible printed circuit board, and a driving chip for controlling the pixels 433a, the touch sensor 431a, or a driving chip for controlling the electrically conductive wires 435b (e.g., the second touch sensor) may be mounted on the connection board 563. In another embodiment, the connection board 593 may transmit a control signal, power, or a touch input detection signal between the signal wire 315 and the processor 591.

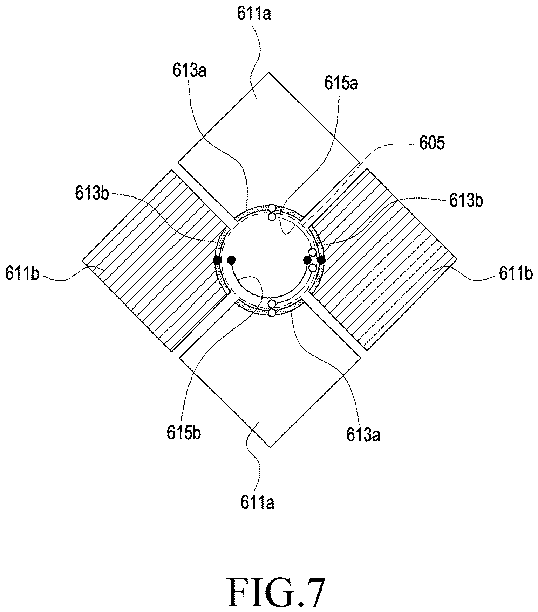

FIG. 7 is an enlarged view illustrating a portion of an electronic device (e.g., the electronic device 100 or 200 of FIG. 1 or 3) according to one of various embodiments disclosed herein.

According to various embodiments, when an opening area 605 (e.g., the opening area 105 or 205 in FIG. 1 or 3) is provided in the screen display area (e.g., the screen display area VA in FIG. 1 or 4) of the display (e.g., the display 101 or 230 in FIG. 1 or 3), the screen display area VA may include a curved edge (e.g., the first section CS1 in FIG. 4) in the periphery of the opening area 605. As in FIG. 3, when the opening area 605 has an elongated hole shape, a portion of the edge of the screen display area VA around the opening area 605 may be formed as a straight section (e.g., the straight sections LS1 and LS2 in FIG. 4), and the remaining portion may be formed as a curved section. Similarly to the embodiment of FIG. 4, opaque layers 613a and 613b corresponding to edges of the screen display area VA may be formed around the opening area 605. In an embodiment, the opaque layers 613a and 613b may have a closed curve (e.g., a circle) shape surrounding the opening area 605. In another embodiment, the opaque layers 613a and 613b may be formed by an arrangement of a plurality of divided electrically conductive wires.

According to various embodiments, when the opaque layers 613a and 613b are formed by an arrangement of a plurality of electrically conductive wires, the electrically conductive wires disposed symmetrically with respect to each other may be electrically connected to each other via connection wires 615a and 615b. For example, the second touch sensor described above with reference to FIG. 4 or 6 may be formed around the opening area 605. In an embodiment, the connection wires 615a and 615b may be disposed on the opening area 605. When a path through which light is incident or emitted is formed through the opening area 605, the connection wirings 615a and 615b disposed on the opening area 605 may be made of a transparent conductive material (e.g., an indium-tin oxide). In some embodiments, the connection wires 615a and 615b may be formed of an opaque conductive material (e.g., a metal mesh or silver nano wire), and when formed of an opaque material, the connection wires 615a and 615b may be formed as a part of the opaque layers 613a and 613b.

According to various embodiments, when the opening area 605 (e.g., the opening area 105 or 605 of FIG. 1 or 3) is formed in the screen display area VA, the mesh electrodes 611a and 611b constituting a touch sensor or unit cells (e.g., the transparent mesh electrodes 311 in FIG. 3) may not be disposed in the opening area 605. For example, a discontinuous section may be formed in the mesh electrodes 611a and 611b constituting the touch sensor (e.g., the touch sensor 431a in FIG. 6). According to an embodiment, in the discontinuous section of the mesh electrodes 611a and 611b caused due to the opening area 605, the opaque layers 613a and 613b or the connection wires 615a and 615b may provide an electrical connection structure. In another embodiment, when an electrical connection structure is provided in the discontinuous section of the mesh electrodes 611a and 611b, the opaque layers 613a and 613b may be disposed on the same layer as the mesh electrodes 611a and 611b. In some embodiments, the opaque layer and the connection wire indicated by the reference numerals "613a and 615a" may form an electrical connection structure connecting the mesh electrodes 611a (or unit cells) in a vertical arrangement, and the opaque layer and the connection wire indicated by reference numerals "613b and 615b" may form an electrical connection structure in a horizontal arrangement connecting the mesh electrodes 611b (or unit cells). For example, the opaque layers 613a and 613b or the connection wires 615a and 615b may resolve a problem of a discontinuous section due to the opening area 605 and may constitute a touch sensor having a stable structure.

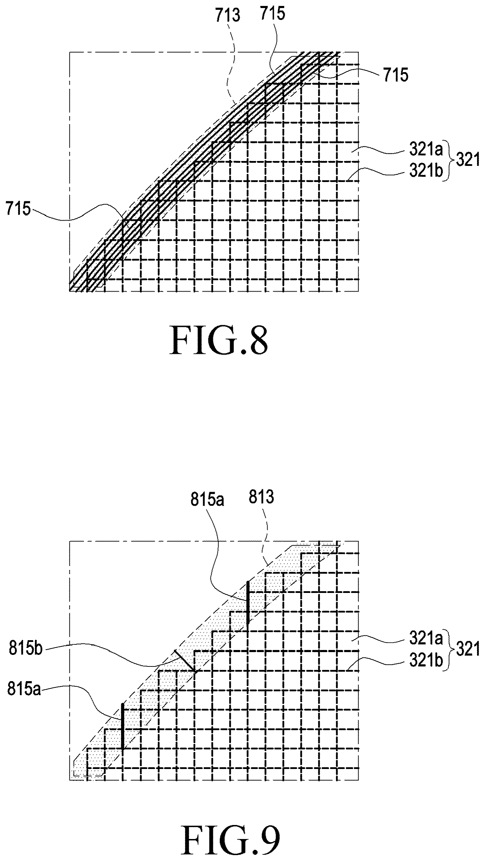

FIGS. 8 and 9 are views for describing an example of implementing an opaque layer 713 or 813 (e.g., the opaque layer 313 in FIG. 4) in an electronic device (e.g., the electronic device 100 or 200 of FIG. 1 or 3) according to various embodiments disclosed herein.

Referring to FIG. 8, when the opaque layer 713 includes a plurality of electrically conductive wires 715 (e.g., the electrically conductive wires 435b in FIG. 6), or when the opaque layer 713 is formed in combination with a plurality of electrically conductive wires 715, the electrically conductive wires 715 may extend in parallel with each other along the trajectory of the first curved section (e.g., the first curved section CS1 in FIG. 4) of the screen display area (e.g., the screen display area VA in FIG. 4). As described above, when the opaque layer 713 includes the electrically conductive wires 715, the electronic device 100 or 200 may include a touch sensor implemented by the opaque layer 713. According to an embodiment, the electrically conductive wires 715 may be colored in different colors. For example, in FIG. 8, the electrically conductive wires 715 may be colored such that saturation or brightness gradually increases (or decreases) from one edge of the opaque layer 713 toward another edge. In some embodiments, since the plurality of the electrically conductive wires 715 are colored in different colors, a visual effect (e.g., gradation effect) may appear around the screen display area (e.g., the screen display area VA in FIG. 4) so that the appearance of the electronic device (e.g., the electronic device 100 or 200 in FIG. 1 or 3) can be made beautiful or diversified. In some embodiments, the opaque layer 713 may have a light transmittance in a certain degree (e.g., about 5 to 50%), and at least some of the colored electrically conductive wires 715 may be visually perceived from the exterior. For example, in a specific embodiment of the disclosure, it is referred to as an "opaque layer", but according to an embodiment, this "opaque layer" may have a little light transmittance.

Referring to FIG. 9, when the opaque layer 813 is formed of one or more electrically conductive wire(s) according to the claimed invention, the opaque layer 813 includes one or more slits 815a and 815b crossing the electrically conductive wire(s). According to an embodiment, the slits 815a and 815b may include a first slit 815a disposed to correspond to the boundary area 321b of a pixel 321 or a second slit 815b disposed in an area not corresponding to pixels 321. In another embodiment, the second slit 815b may be located in a peripheral area (e.g., the peripheral area PA in FIG. 4). For example, when viewed from above the front plate (e.g., the front plate 102 or 220 in FIG. 1 or 3), the first slit 815a or the second slit 815b may be disposed adjacent to the light-emitting area 321a of a pixel 321, and may not substantially overlap the light-emitting area 321a. In another embodiment, when the opaque layer 813 is disposed to overlap a portion of a touch sensor (e.g., the touch sensor 431a in FIG. 5), the opaque layer 813 may further include other slit(s) at a position corresponding to the mesh electrodes constituting the touch sensor. In some embodiments, the arrangement of the first slit 815a or the second slit 815b described above may prevent the light output from the screen display area VA from being emitted to the exterior through the first slit 815a or the second slit 815b. For example, even when the first slit 815a or the second slit 815b is provided, the opaque layer 813 may prevent the first curved section CS1 of the screen display area VA from being visually recognized as a sawtooth shape or a step shape.

According to various embodiments, when the first slit 815a or the second slit 815b is provided in the opaque layer 813, interference between the touch sensor (e.g., the touch sensor 431a in FIG. 6) integrated into the first substrate of the display and the second touch sensor (e.g., implemented using the electrically conductive wires 435b in FIG. 6) implemented with the opaque layer 813 can be suppressed, and the accuracy of the touch sensor or the second touch sensor can be improved. For example, by providing the first slit 815a or the second slit 815b, a phenomenon forming capacitive coupling between different conductive patterns (e.g., the mesh electrodes of the touch sensor 431a in FIG. 6) adjacent to the electrically conductive wires of the opaque layer 813 may be prevented.

According to various embodiments, the opaque layer 813 may be divided into a plurality of areas by slits (e.g., the first slit 815a or the second slit 815b). In an embodiment, one of the plurality of areas may overlap a first transparent electrode among the transparent electrodes of the touch sensor when viewed from above the front plate (e.g., the front plate 220 in FIG. 3). In another embodiment, one of the plurality of areas may be electrically connected to the first transparent electrode while overlapping the first transparent electrode among the transparent electrodes of the touch sensor. In the state of being electrically connected to the first transparent electrode, one of the plurality of areas (e.g., a portion of the opaque layer 813) may expand a touch detection area formed via the first transparent electrode. When one of the areas of the opaque layer 813 is disposed to overlap the first transparent electrode, it may not overlap other transparent electrodes around the first transparent electrode. For example, one of the areas of the opaque layer 813 may be electrically connected to the first transparent electrode or form a capacitive coupling with the first transparent electrode, and may be electrically isolated from other transparent electrodes around the first transparent electrode.

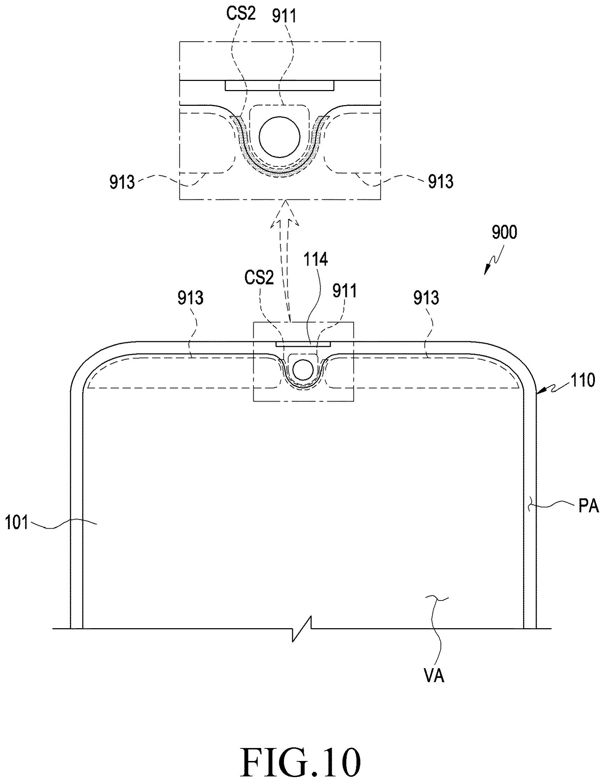

FIG. 10 is a cross-sectional view illustrating a portion of an electronic device 900 (e.g., the electronic device 100 or 200 in FIG. 1 or 3) according to another one of various embodiments disclosed herein.

Referring to FIG. 10, the electronic device 900 may include a first protrusion area 911 formed by a portion of the peripheral area PA (e.g., the peripheral area PA in FIG. 1 or 4) protruding inside the screen display area VA (e.g., FIG. 1 or 4) in the upper end portion. For example, the first protrusion area 911 is a portion of the peripheral area PA and may be disposed to be partially surrounded by the screen display area VA. In some embodiments, the screen display area VA may include a second curved section CS2 surrounding the first protrusion area 911. In an embodiment, the screen display area VA may further include a pair of second protrusion areas 913 disposed on opposite sides of the first protrusion area 911. For example, the first protrusion area 911 may be disposed between the second protrusion areas in the widthwise direction X of the electronic device 900 (e.g., in the X direction in FIG. 3). In another embodiment, the first protrusion area 911 may be disposed between the second protrusion areas 913 in the longitudinal direction Y of the electronic device 900 (e.g., the Y direction in FIG. 3) according to the appearance or design of the electronic device. Although not illustrated, an opaque layer 313 or 435a similar to that of FIG. 4 or 5 may be provided to correspond to the second curved section CS2. In some embodiments, the opaque layer provided to correspond to the second curved section CS2 may be disposed to overlap some of the pixels (e.g., the pixels indicated by reference numerals "P1" and "P2" in FIG. 4) constituting the screen display area VA of the display 101, and may be implemented as a second touch sensor as in FIG. 4 or 6.

In the embodiment illustrated in FIG. 10, the structure in which the first protrusion area 911 has a half circle shape is exemplified, but it should be noted that the disclosure is not limited thereto. For example, the first protrusion area 911 may have a trapezoidal or quadrangular shape by extending to the left or right more than the shape illustrated in FIG. 10. When the first protrusion area 911 has a trapezoidal or quadrangular shape, at least a portion of the boundary between the first protrusion area 911 and the screen display area VA may be configured as a curved section (e.g., the second curved section CS2). In another embodiment, another portion of the peripheral area PA may form one of the second protrusion areas 913. For example, about half of the upper end portion of the screen display area VA in the widthwise direction (e.g., the X direction in FIG. 3) may be formed as the first protrusion area 911, and the remainder may be formed as the second protrusion areas 913. In this way, the first protrusion area 911 may have a shape that is expanded more than the shape illustrated in FIG. 10. When the first protrusion area 911 has a shape that is extended more than the shape illustrated in FIG. 10, sensor(s) for detecting a surrounding operating environment of the electronic device (e.g., the electronic device 100 or 200 in FIG. 1 or 3), such as a proximity sensor, an illuminance sensor, an atmospheric pressure sensor, or a humidity sensor, may be disposed in the first protrusion area 911.

As described above, according to the claimed embodiments disclosed herein, an electronic device (e.g., the electronic device 100, 200, or 900 in FIG. 1, 3, or 10) includes a housing (e.g., the housing 110 in FIG. 1) including a front plate (e.g., the front plate 102 or 220 of FIG. 1 or 3) oriented in a first direction, a rear plate (e.g., the rear plate 111 or 280 of FIG. 1 or 3) oriented in a second direction opposite to the first direction, and a side structure (e.g., the side structure 210 in FIG. 3) at least partially surrounding a space between the front plate and the rear plate, a display (e.g., the display 101 or 230 in FIG. 1, 3, or 10) disposed between the front plate and the rear plate and including a plurality of pixels (e.g., the pixels 321, P1 and P2, or 435a in FIGS. 4 to 6) to output a screen through the front plate, wherein the display includes at least one curved section (e.g., the first or second curved section CS1 or CS2 in FIG. 4 or 10) in which the pixels (e.g., pixels P1 and P2 in FIG. 4) are arranged along a curved trajectory in an edge of the screen display area (e.g., the screen display area VA in FIG. 1, 4, or 10) when viewed from above the front plate, an opaque layer (e.g., the opaque layers 313, 435a, 613a, 613b, 713, and 813 in FIGS. 4 to 9) disposed to correspond to at least the curved section of the screen display area. When viewed from above the front plate, the opaque layer covers at least some of the pixels arranged in the curved section.

According to various embodiments, the opaque layer may block a portion of light output from the screen display area from being emitted to an exterior at least in the curved section.

According to various embodiments, the curved section may form a corner connecting two straight sections (e.g., the straight sections LS1 and LS2 in FIG. 4) disposed perpendicular to each other among the edges of the screen display area.

According to various embodiments, the electronic device described above may further include a peripheral area (e.g., the peripheral area PA in FIG. 1, 4, or 10) disposed around the screen display area when viewed from above the front plate, and the peripheral area may include a first protrusion area (e.g., the first protrusion area 911 in FIG. 10) at least partially surrounded by the screen display area, and the curved section may be disposed along the perimeter of the first protrusion area.

According to various embodiments, the screen display area may further include a pair of second protrusion areas (e.g., the second protrusion areas 913 in FIG. 10), wherein the first protrusion area may be disposed between the second protrusion areas in a longitudinal direction or a widthwise direction of the electronic device.

According to various embodiments, the display may further include an opening area (e.g., the opening area 105, 205, or 605 in FIG. 1, 2, or 7) surrounded by the screen display area, wherein the pixels are not disposed in the opening area, and the curved section may include at least a portion of the perimeter of the opening area.

According to various embodiments, the opening area may provide a path through which light is incident from the exterior to the interior of the front plate.

According to various embodiments, the opening area (e.g., the opening area 205 in FIG. 2) may have an elongated hole shape extending in one direction when viewed from above the front plate.

According to the claimed embodiments, the opaque layer includes at least one electrically conductive wire (e.g., the electrically conductive wires 435b and 715 in FIG. 6 or 8) extending along the curved section.

According to various embodiments, the electronic device described above may further include a printed circuit board (e.g., the printed circuit board 240 in FIG. 3) disposed between the display and the rear plate, a processor (e.g., the processor 591 in FIG. 6) mounted on the printed circuit board, and a signal wire connecting the electrically conductive wire to the printed circuit board (e.g., the signal wire 315 in FIG. 4 or the wiring layer 539a in FIG. 6), wherein the processor may be configured to detect a user's touch input using the electrically conductive wire.

According to the claimed embodiments, the opaque layer further includes at least one slit (e.g., the slits 815a and 815b in FIG. 9) disposed to cross the electrically conductive wire.

According to various embodiments, the electronic device described above may further include a peripheral area disposed around the screen display area when viewed from above the front plate, at least one slit disposed to cross the electrically conductive wire while overlapping the peripheral area when viewed from above of the front plate.

According to various embodiments, the opaque layer may further include at least one slit disposed to cross the electrically conductive wire, and the slit may be disposed adjacent to the light-emitting area (e.g., the light-emitting area 321a in FIG. 4 or 9) of the pixel not to overlap the light-emitting area of the pixels.

According to the claimed embodiments, the display includes a first substrate (e.g., the first substrate 431 in FIG. 5 or 6) integrated with a touch sensor (e.g., the touch sensor 321 or 431a in FIGS. 4 to 6), and a second substrate (e.g., the second substrate 433 in FIG. 5 or 6) coupled to the first substrate to face the first substrate and sealing the pixels, and the opaque layer is stacked on the first substrate.

According to various embodiments, the electronic device described above may further include a printed circuit board disposed between the display and the rear plate, a processor mounted on the printed circuit board, and a signal wire connected to the printed circuit board, wherein the opaque layer is disposed to correspond to at least a portion of an edge of an area in which the pixels are arranged and the at least one electrically conductive wire is electrically connected to the processor via the signal wire, and the processor may be configured to detect a user's touch input using the electrically conductive wire.

In the foregoing detailed description, specific embodiments have been described. However, it will be evident to a person ordinarily skilled in the art that various modifications can be made without departing from the scope of the disclosure as long as they fall into the scope of the appended claims.

## Claims

1. An electronic device (100; 200; 900) comprising:
a housing (110) including:
a front plate (102; 220) oriented to face a first direction,
a rear plate (111) arranged below the front plate and oriented to face a second direction opposite to the first direction, and
a side structure (118; 210) disposed to at least partially surround a space between the front plate and the rear plate;
a display (101; 230; 430) disposed between the front plate and the rear plate and including a plurality of pixels configured to output a screen through the front plate,
wherein, when viewed from above the front plate, the display (101) includes a curved section (CS1; CS2) in which the pixels are arranged, at the edge of a screen display area, along a curved trajectory; and
an opaque layer (313; 435a; 813) disposed to correspond to the curved section (CS1) of the screen display area,
wherein, when viewed from above the front plate, the opaque layer (313; 435a; 813) covers at least some of the pixels arranged in the curved section (CS1; CS2),
**characterized in that** the display (101; 230; 430) includes a first substrate (431) in which a first touch sensor (431a) is integrated and on which the opaque layer (313; 435a; 813) is stacked, and a second substrate (433) coupled to face the first substrate (431) and sealing the pixels, and
wherein the opaque layer (313; 435a; 813) includes at least one electrically conductive wire (435b) extending along the curved section and implementing a second touch sensor, and at least one slit (815a; 815b) disposed to cross the at least one electrically conductive wire (435b).

2. The electronic device of claim 1, wherein the opaque layer (313; 435a; 813) is configured to block a portion of light output from the screen display area from being emitted to an exterior at least in the curved section (CS1; CS2).

3. The electronic device of claim 1, wherein the curved section (CS1; CS2) forms a corner connecting two straight sections disposed perpendicular to each other among edges of the screen display area.

4. The electronic device of claim 1, further comprising:
a peripheral area (PA) disposed around the screen display area when viewed from above of the front plate,
wherein the peripheral area (PA) includes a first protrusion area (911) at least partially surrounded by the screen display area, and the curved section (CS1; CS2) is disposed along a perimeter of the first protrusion area (911).

5. The electronic device of claim 4, wherein the screen display area further includes a pair of second protrusion areas (913), and
the first protrusion area (911) is disposed between the second protrusion areas (913) in a longitudinal direction or a widthwise direction of the electronic device.

6. The electronic device of claim 1, wherein the display further includes an opening area (105; 205; 605) surrounded by the screen display area, wherein the pixels are not disposed in the opening area, and
the curved section (CS1; CS2) includes at least a portion of the perimeter of the opening area (105; 205; 605).

7. The electronic device of claim 6, wherein the opening area (105; 205; 605) is configured to provide a path through which light is incident from an exterior to an interior of the front plate. (110A).

8. The electronic device of claim 6, wherein the opening area (105; 205; 605) has an elongated hole shape extending in one direction when viewed from above the front plate.

9. The electronic device of claim 1, further comprising:
a printed circuit board (240) disposed between the display (101; 230; 430) and the rear plate;
a processor (591) mounted on the printed circuit board (240); and
a signal wire (315; 539a) configured to connect the at least one electrically conductive wire (435b) to the printed circuit board (240),
wherein the processor (591) is configured to detect a user's touch input using the at least one electrically conductive wire (435b).

10. The electronic device of claim 1, wherein the at least one slit (815a; 815b) is disposed adjacent to a light-emitting area of the pixels, without overlapping the light-emitting area of the pixels.

## Patentansprüche

1. Elektronische Vorrichtung (100; 200; 900), umfassend:
ein Gehäuse (110), das Folgendes enthält:
eine Frontplatte (102; 220), die so ausgerichtet ist, dass sie in eine erste Richtung zeigt,
eine Rückplatte (111), die unterhalb der Frontplatte positioniert und so ausgerichtet ist, dass sie in eine zweite Richtung zeigt, die der ersten Richtung entgegengesetzt ist, und
eine Seitenstruktur (118; 210), die so angeordnet ist, dass sie einen Raum zwischen der Frontplatte und der Rückplatte mindestens teilweise umgibt;
eine Anzeige (101; 230; 430), die zwischen der Frontplatte und der Rückplatte angeordnet ist und eine Vielzahl von Pixeln enthält, die dazu konfiguriert sind, einen Bildschirm durch die Frontplatte auszugeben,
wobei die Anzeige (101), wenn sie von oberhalb der Frontplatte betrachtet wird, einen gekrümmten Abschnitt (CS1; CS2) enthält, in dem die Pixel am Rand eines Bildschirmanzeigebereichs entlang einer gekrümmten Bahn positioniert sind; und
eine opake Schicht (313; 435a; 813), die so angeordnet ist, dass sie dem gekrümmten Abschnitt (CS1) des Bildschirmanzeigebereichs entspricht,
wobei die opake Schicht (313; 435a; 813), wenn sie von oberhalb der Frontplatte betrachtet wird, mindestens einige der in dem gekrümmten Abschnitt (CS1; CS2) positionierten Pixel abdeckt,
**dadurch gekennzeichnet, dass**
die Anzeige (101; 230; 430) ein erstes Substrat (431), in das ein erster Berührungssensor (431a) integriert ist und auf dem die opake Schicht (313; 435a; 813) gestapelt ist, und ein zweites Substrat (433), das so gekoppelt ist, dass es zu dem ersten Substrat (431) zeigt, und die Pixel abdichtet, enthält und
wobei die opake Schicht (313; 435a; 813) mindestens einen elektrisch leitenden Draht (435b), der sich entlang des gekrümmten Abschnitts erstreckt und einen zweiten Berührungssensor implementiert, und mindestens einen Schlitz (815a; 815b) enthält, der so angeordnet ist, dass er den mindestens einen elektrisch leitenden Draht (435b) kreuzt.

2. Elektronische Vorrichtung nach Anspruch 1, wobei die opake Schicht (313; 435a; 813) dazu konfiguriert ist, mindestens in dem gekrümmten Abschnitt (CS1; CS2) zu verhindern, dass ein Teil des Lichts, das von dem Bildschirmanzeigebereich ausgegeben wird, zu einem Äußeren emittiert wird.

3. Elektronische Vorrichtung nach Anspruch 1, wobei der gekrümmte Abschnitt (CS1; CS2) eine Ecke bildet, die zwei gerade Abschnitte, die senkrecht zueinander angeordnet sind, aus Rändern des Bildschirmanzeigebereichs verbindet.

4. Elektronische Vorrichtung nach Anspruch 1, ferner umfassend:
einen peripheren Bereich (PA), der um den Bildschirmanzeigebereich herum angeordnet ist, wenn er von oberhalb der Frontplatte betrachtet wird,
wobei der periphere Bereich (PA) einen ersten Vorsprungsbereich (911) enthält, der mindestens teilweise durch den Bildschirmanzeigebereich umgeben ist, und der gekrümmte Abschnitt (CS1; CS2) entlang eines Umfangs des ersten Vorsprungsbereichs (911) angeordnet ist.

5. Elektronische Vorrichtung nach Anspruch 4, wobei der Bildschirmanzeigebereich ferner ein Paar zweiter Vorsprungsbereiche (913) enthält und
der erste Vorsprungsbereich (911) zwischen den zweiten Vorsprungbereichen (913) in einer Längsrichtung oder einer Breitenrichtung der elektronischen Vorrichtung angeordnet ist.

6. Elektronische Vorrichtung nach Anspruch 1, wobei die Anzeige ferner einen Öffnungsbereich (105; 205; 605) enthält, der durch den Bildschirmanzeigebereich umgeben ist, wobei die Pixel nicht in dem Öffnungsbereich angeordnet sind, und
der gekrümmte Abschnitt (CS1; CS2) mindestens einen Teil des Umfangs des Öffnungsbereichs (105; 205; 605) enthält.

7. Elektronische Vorrichtung nach Anspruch 6, wobei der Öffnungsbereich (105; 205; 605) dazu konfiguriert ist, einen Weg bereitzustellen, durch den Licht von einem Äußeren in ein Inneres der Frontplatte einfällt
(110A).

8. Elektronische Vorrichtung nach Anspruch 6, wobei der Öffnungsbereich (105; 205; 605), wenn er von oberhalb der Frontplatte betrachtet wird, eine Form eines Langlochs aufweist, das sich in eine Richtung erstreckt.

9. Elektronische Vorrichtung nach Anspruch 1, ferner umfassend:
eine gedruckte Leiterplatte (240), die zwischen der Anzeige (101; 230; 430) und der Rückplatte angeordnet ist;
einen Prozessor (591), der auf der gedruckten Leiterplatte (240) montiert ist; und
einen Signaldraht (315; 539a), der dazu konfiguriert ist, den mindestens einen elektrisch leitenden Draht (435b) mit der gedruckten Leiterplatte (240) zu verbinden,
wobei der Prozessor (591) dazu konfiguriert ist, eine Berührungseingabe eines Benutzers unter Verwendung des mindestens einen elektrisch leitenden Drahts (435b) zu erkennen.

10. Elektronische Vorrichtung nach Anspruch 1, wobei der mindestens eine Schlitz (815a; 815b) benachbart zu einem lichtemittierenden Bereich der Pixel angeordnet ist, ohne den lichtemittierenden Bereich der Pixel zu überlappen.

## Revendications

1. Dispositif électronique (100 ; 200 ; 900) comprenant :
un boîtier (110) comprenant :
une plaque avant (102 ; 220) orientée pour faire face à une première direction,
une plaque arrière (111)
agencée au-dessous de la plaque avant et orientée pour faire face à une seconde direction opposée à la première direction, et
une structure latérale (118 ; 210) disposée pour entourer au moins partiellement un espace entre la plaque avant et la plaque arrière ;
un dispositif d'affichage (101 ; 230 ; 430) disposé entre la plaque avant et la plaque arrière et comprenant une pluralité de pixels configurés pour émettre en sortie un écran à travers la plaque avant,
lorsqu'il est vu du dessus de la plaque avant, ledit dispositif d'affichage (101) comprenant une section incurvée (CS1 ; CS2) dans laquelle les pixels sont agencés, au niveau du bord d'une zone d'affichage d'écran, le long d'une trajectoire incurvée ; et
une couche opaque (313 ; 435a ; 813) disposée pour correspondre à la section incurvée (CS1) de la zone d'affichage d'écran,
lorsqu'elle est vue du dessus de la plaque avant, ladite couche opaque (313 ; 435a ; 813) recouvrant au moins certains des pixels agencés dans la section incurvée (CS1 ; CS2), **caractérisé en ce que**
le dispositif d'affichage (101 ; 230 ; 430) comprend un premier substrat (431) dans lequel un premier capteur tactile (431a) est intégré et sur lequel la couche opaque (313 ; 435a ; 813) est empilée, et un second substrat (433) couplé pour faire face au premier substrat (431) et scellant les pixels, et
ladite couche opaque (313 ; 435a ; 813) comprenant au moins un fil électriquement conducteur (435b) s'étendant le long de la section incurvée et mettant en oeuvre un second capteur tactile, et au moins une fente (815a; 815b) disposée pour traverser le au moins un fil électriquement conducteur (435b).

2. Dispositif électronique selon la revendication 1, ladite couche opaque (313 ; 435a ; 813) étant configurée pour empêcher une partie de la lumière émise en sortie par la zone d'affichage de l'écran d'être émise vers l'extérieur au moins dans la section incurvée (CS1 ; CS2).

3. Dispositif électronique selon la revendication 1, ladite section incurvée (CS1 ; CS2) formant un coin reliant deux sections droites disposées perpendiculairement l'une à l'autre parmi les bords de la zone d'affichage d'écran.

4. Dispositif électronique selon la revendication 1, comprenant en outre :
une zone périphérique (PA) disposée autour de la zone d'affichage d'écran lorsqu'elle est vue du dessus de la plaque avant,
ladite zone périphérique (PA) comprenant une première zone de saillie (911) au moins partiellement entourée par la zone d'affichage d'écran, et ladite section incurvée (CS1 ; CS2) étant disposée le long d'un périmètre de la première zone de saillie (911).

5. Dispositif électronique selon la revendication 4, ladite zone d'affichage d'écran comprenant en outre une paire de secondes zones de saillie (913), et
ladite première zone de saillie (911) étant disposée entre les secondes zones de saillie (913) dans une direction longitudinale ou une direction dans le sens de la largeur du dispositif électronique.

6. Dispositif électronique selon la revendication 1, ledit dispositif d'affichage comprenant en outre une zone d'ouverture (105 ; 205 ; 605) entourée par la zone d'affichage d'écran, lesdits pixels n'étant pas disposés dans la zone d'ouverture, et
ladite section incurvée (CS1 ; CS2) comprenant au moins une partie du périmètre de la zone d'ouverture (105 ; 205 ; 605).

7. Dispositif électronique selon la revendication 6, ladite zone d'ouverture (105 ; 205 ; 605) étant configurée pour fournir un chemin à travers lequel la lumière est incidente en provenance d'un extérieur vers un intérieur de la plaque avant (110A).

8. Dispositif électronique selon la revendication 6, ladite zone d'ouverture (105 ; 205 ; 605) comportant une forme de trou allongé s'étendant dans une direction lorsqu'elle est vue à partir du dessus de la plaque avant.

9. Dispositif électronique selon la revendication 1, comprenant en outre :
une carte de circuit imprimé (240) disposée entre le dispositif d'affichage (101 ; 230 ; 430) et la plaque arrière ; et
un processeur (591) monté sur la carte de circuit imprimé (240) ; et
un fil de signal (315 ; 539a) configuré pour relier le au moins un fil électriquement conducteur (435b) à la carte de circuit imprimé (240),
ledit processeur (591) étant configuré pour détecter une entrée tactile d'un utilisateur à l'aide du au moins un fil électriquement conducteur (435b).

10. Dispositif électronique selon la revendication 1, ladite au moins une fente (815a ; 815b) étant disposée adjacente à une zone électroluminescente des pixels, sans chevaucher la zone électroluminescente des pixels.
